# EUROPEAN PATENT SPECIFICATION

(11) **EP 2 202 813 B1**
(45) Date of publication and mention of the grant of the patent: **04.04.2012**
(21) Application number: 08172994.9
(22) Date of filing: 29.12.2008
(51) Int. Cl.: H01L 37/04

(54) **Generator apparatus**
Generatorvorrichtung
Appareil de générateur

(43) Date of publication of application: 30.06.2010
(73) Proprietor: ABB Research Ltd., 8050 Zürich (CH)
(72) Inventor: Russberg, Gunnar, 724 62 Västerås (SE)
(74) Representative: Kock, Ina

(56) References cited:
- WO-A-2008/142253
- SOLOMON D: "DESIGN OF A THERMOMAGNETIC GENERATOR" ENERGY CONVERSION AND MANAGEMENT, ELSEVIER SCIENCE PUBLISHERS, OXFORD, GB, vol. 31, no. 2, 1 January 1991 (1991-01-01), pages 157-173, XP000177184 ISSN: 0196-8904

## Description

### TECHNICAL FIELD OF THE INVENTION

The present invention generally relates to a generator apparatus for converting thermal energy to electric energy.

### DESCRIPTION OF RELATED ART AND BACKGROUND OF THE INVENTION

Apparatuses for transforming thermal energy directly into electric energy using a minimum of moving parts have been known since long.

At the end of the 19'th century, Edison and Tesla described devices based on thermomagnetic materials for converting thermal energy into electricity. Edison's pyro-magnetic generator as described in the British patent No. 16709 includes a thermomagnetic working material, means for magnetizing the working material, sources of heat and cold connected to the working material, and a winding enclosing the working material and in which an alternating electric current is induced by thermally cycling the working material. Tesla discloses in U.S. patent No. 428,057 some improvements of Edison's generator by suggesting an alternative heat exchanging mechanism.

Chilowsky discloses in U.S. patent No. 2,510,806 a device for thermomagnetic energy conversion, wherein the temperature variations are achieved by hot and cold fluids in a closed fluid circuit.

Bartels discloses in German patent No. 23 47 377 a device similar to Edison's generator, but suggests gadolinium as magnetic working medium. In one embodiment a permanent magnet is provided to create the magnetic flux in the thermomagnetic material and in another embodiment a battery is used to induce a current in a coil to thereby form an electromagnet to create the magnetic flux.

In WO2008/142253 LEMERCIER et al. describe an electrical energy generation device that contains an element having magnetothermal properties and in thermal contact with hot and cold fluids.

While the apparatuses described above do convert thermal energy directly to electric energy, they seem not to be efficient, compact, optimized for practical use, and/or cost-efficient to manufacture.

### SUMMARY OF THE INVENTION

It is an object of the present invention to provide a generator apparatus for converting thermal energy to electric energy, which is adopted for practical use and which has an improved structure and operation.

It is a particular object of the invention to provide such apparatus, which use a smooth and energetically efficient thermal cycling.

It is still a further object to provide such apparatus, which is reliable, flexible, and of reasonable cost.

These objects, among others, are according to the present invention attained by generator apparatuses as specified in the appended patent claims.

According to one aspect of the invention there is provided a generator apparatus for converting thermal energy to electric energy comprising a core region, windings, C-shaped frame sections, a hot and cold fluid distribution system, and means for creating a magnetic flux as claimed in claim 1.

The core region is made of a magnetic material with a temperature dependent reluctance and has channels running from a first vertical side to a second vertical side of the core region opposite to the first side. The windings are arranged above one another in horizontal planes around the core region.

The C-shaped frame sections are made of a magnetic material and are arranged vertically and in a staggered row alternately around the first and second vertical sides the core region. The core region and the C-shaped frame sections form together a magnetic circuit.

The hot and cold fluid distribution system is connected to the channels of the core region for distributing alternately hot and cold fluid through the channels of the core region to vary the temperature of the core region alternately above and below a selected temperature to, in turn, vary the reluctance of the magnetic circuit. Access to the channels is obtained through spaces between the windings and the C-shaped frame sections on each of the first and second sides of the generator apparatus.

The means for creating a magnetic flux is adapted to create a magnetic flux in the magnetic circuit and may be implemented by a capacitor device connected to the windings, by a current source connected to separate winding arranged around the magnetic circuit, or by a permanent magnet arranged in the magnetic circuit.

The apparatus operates by means of electric currents being induced in the windings in response to a varying magnetic flux in the magnetic circuit caused by the varying reluctance, which in turn is caused by the temperature variation of the core region.

The core region may be made of a material having a magnetic phase transition temperature, such as a Curie temperature or a Néel temperature, which coincides with the selected temperature. Alternatively, the core region may be made of a material having a significant temperature dependent reluctance at the selected temperature.

The generator device of the invention has an efficient design by which large electric power outputs can be obtained without requiring large and thick frames closing the magnetic path and without essential fluid frictional losses and thermal gradients.

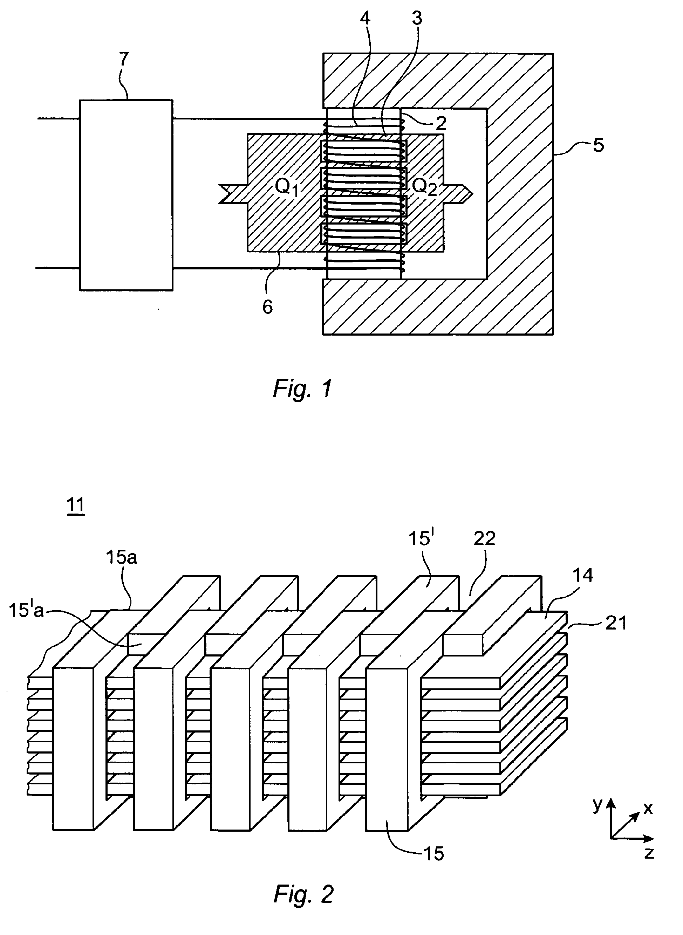

Further characteristics of the invention and advantages thereof, will be evident from the following detailed description of preferred embodiments of the present invention given hereinafter and the accompanying Figs. 1-5, which are given by way of illustration only and thus, are not limitative of the present invention.

### BRIEF DESCRIPTION OF THE DRAWINGS

Fig. 1 displays schematically the general principles of a generator apparatus in accordance with the invention.
Fig. 2 displays schematically in a perspective view major parts of a generator apparatus in accordance with an embodiment of the invention.
Fig. 3 displays schematically in a perspective view a core region as being comprised in the generator apparatus of Fig. 2.
Fig. 4 displays schematically in a transversal cross section the generator apparatus of Fig. 2.
Fig. 5 displays schematically in a longitudinal cross section the generator apparatus of Fig. 2.

### DETAILED DESCRIPTION OF EMBODIMENTS

A generator apparatus for converting thermal energy into electric energy in accordance with the invention comprises, as shown in Fig. 1, a core region 2 made of a magnetic material having a reluctance that is temperature-dependent, preferably highly temperature-dependent, a coil or winding 4, a yoke 5 made of iron or other magnetic material, a hot and cold fluid distribution system 6, and means 7 for creating a magnetic flux in the magnetic circuit formed by the core region 2 and the yoke 5.

The core region 2 has a plurality of channels 3 running through the core region 2. The winding 4 is arranged around the core region 2. The hot and cold fluid distribution system 6 is connected to the channels 3 of the core region 2 for distributing alternately hot and cold fluid through the channels 3 to vary the temperature of the core region 2 alternately above and below a selected temperature to thereby vary the reluctance of the magnetic circuit.

The apparatus operates by means of electric currents being induced in the winding 4 in response to a varying magnetic flux in the magnetic circuit caused by the varying reluctance, which in turn is caused by the temperature variation of the core region 2. The core region 2 may be made of a material having a magnetic phase transition temperature, such as a Curie temperature or a Néel temperature, which coincides with the selected temperature. Alternatively, the core region 2 is made of a material having a significant temperature dependent reluctance at and around the selected temperature. Examples of materials include gadolinium, bismuth, zinc, antimony, tellurium, selenium, lead, silicon, germanium, tin, magnesium, manganese, arsenic, nickel, lanthanum, gallium, phosphorus, calcium, barium, strontium, ytterbium, iron, and any alloy or compound thereof.

The hot and cold fluid distribution system 6 is further detailed in the International patent application publication WO2008/116789 as well as in JP 7107764.

The means 7 for creating the magnetic flux may be a capacitor device arranged to feed the winding 4 with current induced in the winding 4. Alternatively, the means 7 for creating the magnetic flux may be, a current source connected to a further coil or winding arranged around the magnetic circuit, or a permanent magnet.

The operation of the apparatus is further described in the above identified publications as well as in the International patent application publication WO2008/116785 and W02008/116792.

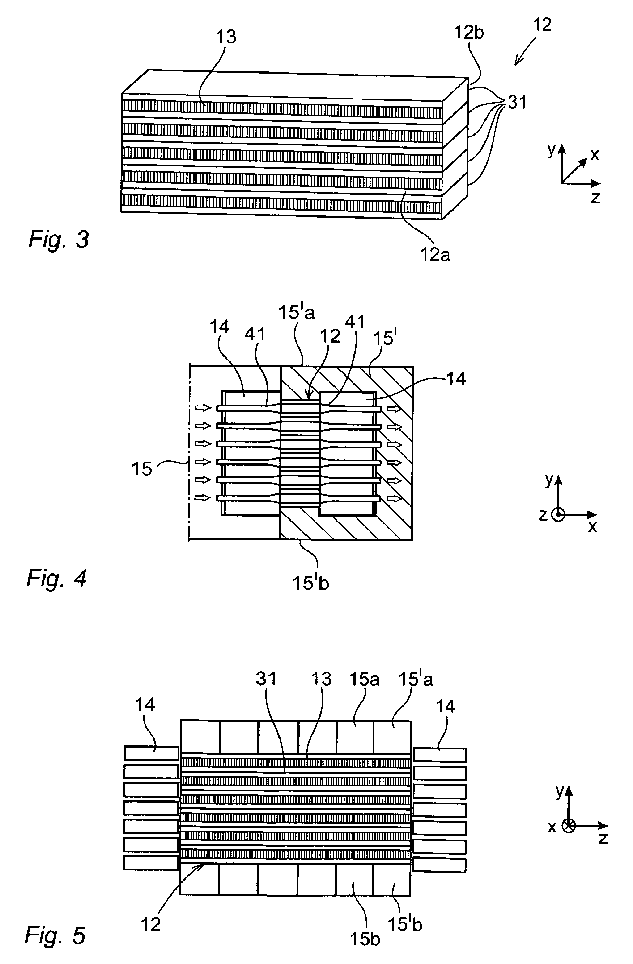

Fig. 2 displays schematically in a perspective view major parts of a generator apparatus 11 in accordance with an embodiment of the invention. The generator apparatus 11 comprises an interior core region 12 which is not visible in the Fig. 2 perspective view, but is separately illustrated in Fig. 3. The core region 12 is made of a magnetic material with a temperature dependent reluctance such as those disclosed with reference to Fig. 1 and comprises a plurality of channels 13 running from a first vertical side 12a to a second vertical side 12b of the core region 12. The vertical direction is the y direction in Figs. 2-3.

Turning back to Fig. 2, the generator apparatus 11 comprises windings 14 connected in series or in parallel with one another. The windings 14 are arranged above one another in horizontal planes around the core region 12. The horizontal planes are the xz planes in Figs. 2-3. The windings 14 are spaced apart by gaps 21. Essentially C- or U-shaped frame sections or yokes 15, 15' are arranged vertically alternately around the first 12a and second 12b vertical sides of the core region 12. The C-shaped frame sections 15, 15' are thus arranged alternately facing the first 12a and second 12b vertical sides of the core region 12 in a staggered row, which extends in a direction z essentially perpendicular to a main direction x of the channels 13 of the core region 12. The C-shaped frame sections 15, 15' at each of the first and second vertical sides 12a-b of the core region 12 are thus spaced apart by gaps 22, the width of which is equal to the width of the C-shaped frame sections 15, 15'. Thus, the channels 13 are accessible through the spaces formed by the gaps 21 between the windings 14 and the gaps 22 between the C-shaped frame sections 15, 15'.

The C-shaped frame sections 15, 15' form with the core region 12 a magnetic circuit by closing a magnetic path alternately on opposite sides of the core region 12 and the windings 14. To this end, the C-shaped frame sections 15, 15' are made of a magnetic material such as iron. A magnetic flow in the core region 12 will thus be in a direction y essentially perpendicular to the main direction x of the channels 13.

Figs. 4 and 5 display schematically in transversal and longitudinal cross sections the generator apparatus of Fig. 2.

The outer ends 15a-b of the C-shaped frame sections 15 arranged around the first vertical side 12a of the core region 12 reach preferably the second vertical side 12b of the core region 12 and the outer ends 15'a-b of the C-shaped frame sections 15' arranged around the second vertical side 12b of the core region 12 reach preferably the first vertical side 12a of the core region 12b as can be seen in Fig. 4.

The core region 12 comprises advantageously a plurality of horizontally arranged core plates 31 on top of one another, wherein the core plates 31 comprise each a row of the channels 13. The pitch of the windings 14, i.e. the center distance between two neighboring windings 14, and the pitch of the core plates 31, i.e. the center distance between two neighboring core plates 31, are similar and wherein the windings 14 are displaced with respect to the core plates 31 to allow access to the rows of channels 13 between the windings 14 in a direction x, which coincides with the main direction x of the channels 13.

For smaller electric power outputs, the generator device 11 may comprise passive material 40 which is not magnetic or which has not a temperature dependent reluctance arranged between each pair of neighboring ones of the core plates 31 in order to obtain a practical height of the generator apparatus and to reduce the width of the windings 14. For larger electric power outputs, this is not required or not even beneficial.

The channels 13 may be straight or have any suitable shape. Advantageously, they have each a height which is larger than the gap 21 between the windings 14 in order to use the core region 12 efficiently. The number and shape of the channels may be selected for each application, design, and electric power output required.

The windings 14 are favorably arranged between the core region 12 and the essentially C-shaped frame sections 15, 15', wherein the C-shaped frame sections 15, 15' may be spaced apart from the windings 14 in a direction coinciding with the main direction x of the channels 13 of the core region 12 in order to facilitate the connection of a hot and cold fluid distribution system (not illustrated in Figs. 2-5).

The hot and cold fluid distribution system is provided for distributing alternately hot and cold fluid through the channels 13 to vary the temperature of the core region 12 alternately above and below a selected temperature to thereby vary the reluctance of the magnetic circuit. The hot and cold fluid distribution system comprises advantageously fluid connection end portions 41 as shown in Fig. 4 connected to the channels 13, wherein the fluid connection end portions 41 have cross sectional areas which preferably increase gradually towards the channels 13. A gradually increasing height towards the channels 13 may be required when the channels have a height which is larger than the distance between adjacent windings 14. A gradually increasing width towards the channels 13 may be required when the fluid connection end portions 41 should be connected to channels 13 which are lying straight behind the C-shaped frame sections 15, 15' and which are thus not facing the gaps 22 between the C-shaped frame sections 15, 15'. The fluid connection end portions 41 may be comprised of pipes or hoses or similar structures. In other respects, the hot and cold fluid distribution system may be implemented as described with reference to Fig. 1.

Finally, an arrangement (not illustrated in Figs. 2-5) for creating a magnetic flux in the magnetic circuit is provided. The arrangement for creating the magnetic flux may be implemented as described with reference to Fig. 1.

The generator apparatus of the present invention reduces the requirements on the frame section thickness and allows for direct and simple fluid access to the channels 13.

Fluid frictional losses and thermal gradients set a limit on the thickness of the generator apparatus 11, i.e. on the dimension of the generator apparatus 11 in the main direction x of the channels. This thickness is estimated to be about 0.1-0.2 m.

The generator apparatus 11 is thus designed for a selected output electric power by means of, i.a., the height of the core region 12, the height of the C-shaped frame sections 15, 15', and the number of the windings 14; and/or by means of the length of the core region 12, the length of the windings 14, and the number of the C-shaped frame sections 15, 15', wherein the lengths of the core region 12 and the windings 14 are the dimensions of the core region 12 and the windings 14 in a horizontal direction z essentially perpendicular to the main direction x of the channels 13. In other words, the generator apparatus 11 is scalable in height (y direction) and length (z direction), but advantageously not in thickness (x direction).

It shall be appreciated by a person skilled in the art that the present invention can be implemented in yet further embodiments. In particular, the hot and cold fluid distribution system and the arrangement for creating a magnetic flux in the magnetic circuit may be implemented in other manners than those disclosed above.

## Claims

1. A generator apparatus (11) for converting thermal energy to electric energy comprising:
- a core region (12) made of a magnetic material having a temperature dependent reluctance, the core region having channels (13) running in a main direction (x) from a first vertical side (12a) to a second vertical side (12b) of the core region opposite to the first side of said core region;
- windings (14) arranged above, and spaced apart from, one another in horizontal (xz) planes around said core region;
- essentially C-shaped frame sections (15, 15') of a magnetic material arranged vertically alternately around the first and second vertical sides of the core region so as to alternately face the first and second vertical sides of the core region in a staggered row extending in a horizontal direction (z) essentially perpendicular to the main direction (x) of the channels (13), wherein the core region and the C-shaped frame sections form a magnetic circuit;
- a hot and cold fluid distribution system (6) connected to the channels of said core region for distributing alternately hot and cold fluid through the channels of said core region to vary the temperature of said core region alternately above and below a selected temperature, thereby varying the reluctance of the magnetic circuit; and
- means (7) for creating a magnetic flux in the magnetic circuit.

2. The apparatus of claim 1 wherein said core region is made of a material having a magnetic phase transition temperature, such as a Curie temperature or a Néel temperature, said selected temperature coinciding with said magnetic phase transition temperature.

3. The apparatus of claim 1 wherein said core region is made of a material having a significant temperature dependent reluctance at said selected temperature.

4. The apparatus of any of claims 1-3 wherein said core region comprises a plurality of horizontally arranged core plates (31) on top of one another, and said channels comprises a row of channels in each of the core plates.

5. The apparatus of claim 4 wherein the pitch of the windings and the pitch of the core plates are similar and wherein the windings are displaced with respect to the core plates to allow access to the rows of channels between the windings in a direction (x) which coincides with said main direction of the channels.

6. The apparatus of claim 4 comprising material which is not magnetic or which has not a temperature dependent reluctance arranged between each pair of neighboring ones of the core plates.

7. The apparatus of any of claims 1-6 wherein said channels have each a height which is larger than an average distance between each pair of neighboring ones of the windings.

8. The apparatus of any of claims 1-7 wherein said windings are connected in parallel or in series.

9. The apparatus of any of claims 1-8 wherein said windings are arranged between said core region and said essentially C-shaped frame sections.

10. The apparatus claim 9 wherein said essentially C-shaped frame sections are spaced apart from said windings in a direction (x) coinciding with said main direction of the channels of said core region.

11. The apparatus of any of claims 1-10 wherein the outer ends (15a-b) of the C-shaped frame sections (15) arranged around the first vertical side of the core region reach essentially the second vertical side of the core region and the outer ends (15'a-b) of the C-shaped frame sections (15') arranged around the second vertical side of the core region reach essentially the first vertical side of the core region.

12. The apparatus of any of claims 1-11 wherein said apparatus is designed for a selected output electric power by means of the height of said core region, the height of said C-shaped frame sections, and the number of said windings, and/or by means of the length of said core region, the length of said windings, and the number of said C-shaped frame sections, wherein the lengths of said core region and said windings are the dimension of said core region and said windings in a horizontal direction (z) essentially perpendicular to said main direction (x) of the channels.

13. The apparatus of any of claims 1-12 wherein said a hot and cold fluid distribution system comprises fluid connection end portions (41, 42) connected to the channels, said fluid connection end portions having cross sectional areas which increase towards the channels.

14. The apparatus of any of claims 1-12 wherein said means (7) for creating a magnetic flux in the magnetic circuit includes a capacitor device connected to said windings.

## Patentansprüche

1. Generatorvorrichtung (11) zum Umwandeln von Wärmeenergie in elektrische Energie, umfassend:
- einen Kernbereich (12), der aus einem magnetischen Material hergestellt ist, das einen temperaturabhängigen magnetischen Widerstand aufweist, wobei der Kernbereich Kanäle (13) aufweist, die in eine Hauptrichtung (x) von einer ersten vertikalen Seite (12a) zu einer zweiten vertikalen Seite (12b) des Kernbereichs gegenüber der ersten Seite des Kernbereichs verlaufen,
- Wicklungen (14), die in horizontalen Ebenen (xz) um den Kernbereich herum übereinander und voneinander entfernt angeordnet sind,
- im Wesentlichen C-förmige Rahmenabschnitte (15, 15') aus einem magnetischen Material, die vertikal abwechselnd um die erste und zweite vertikale Seite des Kernbereichs angeordnet sind, um abwechselnd der ersten und zweiten vertikalen Seite des Kernbereichs in einer versetzten Reihe, die in einer horizontalen Richtung (z) im Wesentlichen senkrecht zur Hauptrichtung (x) der Kanäle (13) verläuft, gegenüber zu liegen, wobei der Kernbereich und die C-förmigen Rahmenabschnitte einen magnetischen Kreis bilden,
- ein Verteilungssystem (6) für ein heißes und ein kaltes Fluid, das mit den Kanälen des Kernbereichs verbunden ist, um abwechselnd heißes und kaltes Fluid durch die Kanäle des Kernbereichs zu verteilen, sodass die Temperatur des Kernbereichs abwechselnd über und unter einer gewählten Temperatur wechselt und sich **dadurch** der magnetische Widerstand des magnetischen Kreises ändert, und
- Mittel (7) zum Erzeugen eines Magnetflusses in dem magnetischen Kreis.

2. Vorrichtung nach Anspruch 1, wobei der Kernbereich aus einem Material hergestellt ist, das eine Temperatur der magnetischen Phasenumwandlung wie eine Curie-Temperatur oder Néel-Temperatur aufweist, wobei die gewählte Temperatur mit der Temperatur der magnetischen Phasenumwandlung übereinstimmt.

3. Vorrichtung nach Anspruch 1, wobei der Kernbereich aus einem Material hergestellt ist, das einen beträchtlichen temperaturabhängigen magnetischen Widerstand bei der gewählten Temperatur aufweist.

4. Vorrichtung nach einem der Ansprüche 1 bis 3, wobei der Kernbereich eine Vielzahl horizontal angeordneter Kernplatten (31) übereinander aufweist und die Kanäle eine Reihe von Kanälen in jeder der Kernplatten umfassen.

5. Vorrichtung nach Anspruch 4, wobei der Mittenabstand der Wicklungen und der Mittenabstand der Kernplaften ähnlich sind und wobei die Wicklungen zu den Kernplatten versetzt sind, damit die Reihen der Kanäle zwischen den Wicklungen in einer Richtung (x), die mit der Hauptrichtung der Kanäle übereinstimmt, zugänglich sind.

6. Vorrichtung nach Anspruch 4, die ein Material umfasst, das nicht magnetisch ist oder das keinen temperaturabhängigen magnetischen Widerstand aufweist und das zwischen jedem Paar benachbarter Kernplatten angeordnet ist.

7. Vorrichtung nach einem der Ansprüche 1 bis 6, wobei die Kanäle jeweils eine Höhe aufweisen, die größer ist als der durchschnittliche Abstand zwischen jedem Paar benachbarter Wicklungen.

8. Vorrichtung nach einem der Ansprüche 1 bis 7, wobei die Wicklungen parallel oder in Reihe geschaltet sind.

9. Vorrichtung nach einem der Ansprüche 1 bis 8, wobei die Wicklungen zwischen dem Kernbereich und den im WesentlichenC-förmigen Rahmenabschnitten angeordnet sind.

10. Vorrichtung nach Anspruch 9, wobei die im Wesentlichen C-förmigen Rahmenabschnitte von den Wicklungen in einer Richtung (x), die mit der Hauptrichtung der Kanäle des Kernbereichs übereinstimmt, entfernt sind.

11. Vorrichtung nach einem der Ansprüche 1 bis 10, wobei die äußeren Enden (15a und 15b) der C-förmigen Rahmenabschnitte (15), die um die erste vertikale Seite des Kernbereichs angeordnet sind, im Wesentlichen die zweite vertikale Seite des Kernbereichs erreichen, und die äußeren Enden (15'a und 15'b) der C-förmigen Rahmenabschnitte (15'), die um die zweite vertikale Seite des Kernbereichs angeordnet sind, im Wesentlichen die erste vertikale Seite des Kernbereichs erreichen.

12. Vorrichtung nach einem der Ansprüche 1 bis 11, wobei die Vorrichtung mittels der Höhe des Kernbereichs, der Höhe der C-förmigen Rahmenabschnitte und der Anzahl der Wicklungen und/oder mittels der Länge des Kernbereichs, der Länge der Wicklungen und der Anzahl der C-förmigen Rahmenabschnitte für eine ausgewählte elektrische Ausgangsleistung ausgelegt ist, wobei die Länge des Kernbereichs und der Wicklungen die Abmessung des Kernbereichs und der Wicklungen in einer horizontalen Richtung (z) im Wesentlichen senkrecht zu der Hauptrichtung (x) der Kanäle ist.

13. Vorrichtung nach einem der Ansprüche 1 bis 12, wobei das Verteilungssystem für ein heißes und ein kaltes Fluid Fluidanschlussendabschnitte (41, 42) umfasst, die mit den Kanälen verbunden sind, wobei die Fluidanschlussendabschnitte Querschnittsbereiche aufweise, die in Richtung der Kanäle größer werden.

14. Vorrichtung nach einem der Ansprüche 1 bis 12, wobei das Mittel (7) zum Erzeugen eines Magnetflusses in dem magnetischen Kreis eine Kondensatoreinrichtung aufweist, die mit den Wicklungen verbunden ist.

## Revendications

1. Appareil de générateur (11) pour convertir de l'énergie thermique en énergie électrique comprenant :
- une zone de noyau (12) fabriquée en un matériau magnétique présentant une reluctance dépendante de la température, la zone de noyau présentant des canaux (13) s'étendant dans une direction principale (x) d'un premier côté vertical (12a) à un second côté vertical (12b) de la zone de noyau opposé au premier côté de ladite zone de noyau ;
- des enroulements (14) agencés les uns au-dessus des autres et espacés les uns des autres dans des plans horizontaux (xz) autour de ladite zone de noyau ;
- des sections de cadre (15,15') sensiblement en forme de C en un matériau magnétique agencées verticalement en alternance autour des premier et second côtés verticaux de la zone de noyau de façon à faire face en alternance au premier et au second côté vertical de la zone de noyau dans une rangée décalée s'étendant dans une direction horizontale (z) sensiblement perpendiculaire à la direction principale (x) des canaux (13), dans lequel la zone de noyau et les sections de cadre en forme de C forment un circuit magnétique ;
- un système de distribution (6) de fluide chaud et froid connecté aux canaux de ladite zone de noyau pour distribuer en alternance un fluide chaud et froid à travers les canaux de ladite zone de noyau pour faire varier la température de ladite zone de noyau en alternance au-dessus et en dessous d'une température sélectionnée, faisant varier ainsi la reluctance du circuit magnétique ; et
- un moyen (7) de création d'un flux magnétique dans le circuit magnétique.

2. Appareil selon la revendication 1, dans lequel ladite zone de noyau est fabriquée en un matériau présentant une température de transition de phase magnétique, telle qu'une température de Curie ou une température de Néel, ladite température sélectionnée coïncidant avec ladite température de transition de phase magnétique.

3. Appareil selon la revendication 1, dans lequel ladite zone de noyau est fabriquée en un matériau présentant une reluctance dépendante de la température significative à ladite température sélectionnée.

4. Appareil selon l'une quelconque des revendications 1 à 3, dans lequel ladite zone de noyau comprend une pluralité de plaques de noyau (31) agencées horizontalement les unes sur les autres, et lesdits canaux comprennent une rangée de canaux dans chacune des plaques de noyau.

5. Appareil selon la revendication 4, dans lequel le pas des enroulements et le pas des plaques de noyau sont similaires et dans lequel les enroulements sont décalés par rapport aux plaques de noyau pour permettre l'accès aux rangées de canaux entre les enroulements dans une direction (x) qui coïncide avec ladite direction principale des canaux.

6. Appareil selon la revendication 4, comprenant un matériau qui n'est pas magnétique ou qui n'a pas une reluctance dépendante de la température agencé entre chaque paire de plaques de noyau voisines.

7. Appareil selon l'une quelconque des revendications 1 à 6, dans lequel lesdits canaux présentent chacun une hauteur qui est supérieure à une distance moyenne entre chaque paire d'enroulements voisins.

8. Appareil selon l'une quelconque des revendications 1 à 7, dans lequel lesdits enroulements sont connectés en parallèle ou en série.

9. Appareil selon l'une quelconque des revendications 1 à 8, dans lequel lesdits enroulements sont agencés entre ladite zone de noyau et lesdites sections de cadre sensiblement en forme de C.

10. Appareil selon la revendication 9, dans lequel lesdites sections de cadre sensiblement en forme de C sont espacées desdits enroulements dans une direction (x) coïncidant avec ladite direction principale des canaux de ladite zone de noyau.

11. Appareil selon l'une quelconque des revendications 1 à 10, dans lequel les extrémités extérieures (15a-b) des sections de cadre (15) en forme de C agencées autour du premier côté vertical de la zone de noyau atteignent sensiblement le second côté vertical de la zone de noyau et les extrémités extérieures (15'a-b) des sections de cadre (15') en forme de C agencées autour du second côté vertical de la zone de noyau atteignent sensiblement le premier côté vertical de la zone de noyau.

12. Appareil selon l'une quelconque des revendications 1 à 11, dans lequel ledit appareil est conçu pour une puissance électrique de sortie sélectionnée au moyen de la hauteur de ladite zone de noyau, de la hauteur desdites sections de cadre en forme de C, et du nombre desdits enroulements, et/ou au moyen de la longueur de ladite zone de noyau, de la longueur desdits enroulements, et du nombre desdites sections de cadre en forme de C, dans lequel la longueur de ladite zone de noyau et desdits enroulements est la dimension de ladite zone de noyau et desdits enroulements dans une direction horizontale (z) sensiblement perpendiculaire à ladite direction principale (x) des canaux.

13. Appareil selon l'une quelconque des revendications 1 à 12, dans lequel ledit système de distribution d'un fluide chaud et froid comprend des portions d'extrémité (41, 42) de raccordement fluidique connectées aux canaux, lesdites portions d'extrémité de raccordement fluidique présentant des surfaces de section transversale qui augmentent vers les canaux.

14. Appareil selon l'une quelconque des revendications 1 à 12, dans lequel ledit moyen (7) de création d'un flux magnétique dans le circuit magnétique inclut un dispositif de condensateur connecté auxdits enroulements.
